# FASCICULE DE BREVET EUROPEEN

(11) **EP 2 923 227 B1**
(45) Date de publication et mention de la délivrance du brevet: **12.02.2020**
(21) Numéro de dépôt: 13789797.1
(22) Date de dépôt: 12.11.2013
(51) Int. Cl.: G01V 3/08

(54) **PROCEDE DE RECONNAISSANCE AUTOMATIQUE D'UN OBJET MAGNETIQUE MOBILE**
VERFAHREN ZUR AUTOMATISCHEN ERKENNUNG EINES BEWEGTEN MAGNETISCHEN OBJEKTS
METHOD FOR AUTOMATICALLY RECOGNISING A MOVING MAGNETIC OBJECT

(30) Priorité: 20.11.2012 FR 1261044
(43) Date de publication de la demande: 30.09.2015
(73) Titulaire: Commissariat à l'Energie Atomique et aux Energies Alternatives, 75015 Paris (FR)
(72) Inventeur: HAUTSON, Tristan, 38600 Fontaine (FR); ALOUI, Rabeb, 38600 Fontaine (FR); ALOUI, Saifeddine, 38000 Grenoble (FR); JOBERT, Timothée, 38000 Grenoble (FR)
(74) Mandataire: GIE Innovation Competence Group
(86) Numéro de dépôt international: PCT/EP2013/073656
(87) Numéro de publication internationale: WO 2014/079740

(56) Documents cités:
- GB-A- 2 310 930
- US-A- 5 337 259
- US-A- 5 444 669
- US-A- 5 831 873
- US-A1- 2007 276 218
- US-B1- 6 263 230
- US-B1- 7 932 718

## Description

L'invention concerne un procédé et un appareil de reconnaissance automatique d'un objet magnétique mobile. L'invention concerne également un support d'enregistrement d'informations pour la mise en œuvre de ce procédé ainsi qu'un système d'identification comportant l'appareil de reconnaissance automatique.

Ici, par « objet magnétique », on désigne un objet comportant des pièces ou des parties réalisées dans un matériau magnétique. Un matériau magnétique est un matériau qui présente des propriétés magnétiques mesurables par un appareil de reconnaissance automatique d'objet magnétique.

Par « mobile », on désigne un objet qui peut être déplacé. Ainsi, l'objet magnétique mobile ne se présente pas toujours dans la même position devant l'appareil de reconnaissance. Or le champ magnétique mesuré par chaque magnétomètre du réseau dépend de la position et de l'orientation de l'objet magnétique présenté. Ainsi, il est très difficile de reconnaître de façon fiable la signature magnétique d'un objet magnétique mobile. Jusqu'à présent ce problème a été contourné, par exemple, en fixant des étiquettes RFID (« Radio Frequency Identification ») sur l'objet magnétique ou en imposant un déplacement de l'objet magnétique le long d'une trajectoire prédéterminée pour qu'il puisse être reconnu.

De l'état de la technique est également connu de GB2310930A, US7932718B1, US6263230B1, US2007/276218A1, US5444669A, US5337259A et US5831873A.

L'invention propose une autre solution exploitant le fait que l'objet est magnétique. Elle a donc pour objet un procédé de reconnaissance automatique d'un objet magnétique mobile conforme à la revendication 1.

Dans le procédé ci-dessus, les caractéristiques distinctives calculées à partir des mesures des magnétomètres du réseau sont indépendantes de la position et de l'orientation de l'objet magnétique par rapport au réseau de magnétomètres. Ainsi, l'objet magnétique peut être reconnu quelle que soit sa position par rapport au réseau de magnétomètres. L'objet magnétique peut également être reconnu même s'il se déplace devant le réseau de magnétomètres.

De plus, l'utilisation de systèmes d'équations permettant de déterminer la position, l'orientation et l'amplitude du moment magnétique de plusieurs dipôles magnétiques présents au sein du même objet magnétique, permet d'accroître considérablement le nombre d'objets magnétiques susceptibles d'être reconnus ainsi que la fiabilité de la reconnaissance de chacun de ces objets ;

Enfin, le fait de sélectionner, en fonction de l'objet présenté, le système d'équations qui minimise l'erreur, permet d'augmenter la fiabilité du procédé et permet également le dénombrement du nombre de dipôles magnétiques présents à l'intérieur de l'objet magnétique.

Les modes de réalisation de ce procédé peuvent comporter une ou plusieurs des caractéristiques des revendications dépendantes.

Ces modes de réalisation du procédé de reconnaissance présentent en outre les avantages suivants :
- l'utilisation d'un algorithme d'estimation de solutions d'un système d'équations non-linéaire permet d'accroître la fiabilité du procédé.

L'invention a également pour objet un support d'enregistrement d'informations conforme à la revendication 4.

L'invention a également pour objet un appareil de reconnaissance automatique d'un objet magnétique conforme à la revendication 5.

Enfin, l'invention a également pour objet un système d'identification conforme à la revendication 6.

L'invention sera mieux comprise à la lecture de la description qui va suivre, donnée uniquement à titre d'exemple non limitatif et faîte en se référant aux dessins sur lesquels :
- la figure 1 est une illustration schématique d'un système d'identification comportant un objet à reconnaître et un appareil de reconnaissance automatique d'objets magnétiques ;
- la figure 2 est une illustration schématique et partielle d'un réseau de magnétomètres utilisé dans l'appareil de reconnaissance du système de la figure 1 ;
- la figure 3 est une illustration schématique d'une base de données utilisée dans l'appareil de reconnaissance du système de la figure 1 ;
- la figure 4 est une illustration schématique en vue de dessus des dipôles magnétiques d'un objet magnétique connu utilisé lors de la calibration du système de la figure 1 ;
- la figure 5 est un organigramme d'un procédé de reconnaissance automatique d'un objet magnétique à l'aide du système de la figure 1.

Dans ces figures, les mêmes références sont utilisées pour désigner les mêmes éléments.

Dans la suite de cette description, les caractéristiques et les fonctions bien connues de l'homme du métier ne sont pas décrites en détail.

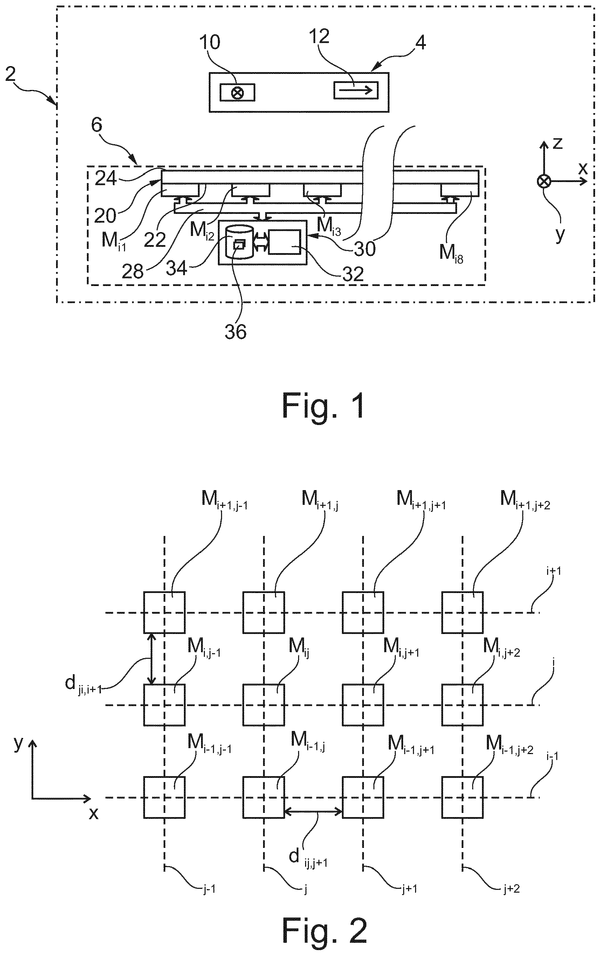

La figure 1 représente un système 2 d'identification. Le système 2 comporte un objet magnétique 4 à reconnaître et un appareil 6 de reconnaissance automatique d'objets magnétiques.

L'objet 4 est librement déplaçable dans un repère orthogonal X, Y, Z fixé sans aucun degré de liberté à l'appareil 6. Ici, les directions X et Y sont horizontales et la direction Z est verticale.

Typiquement, l'objet 4 est librement déplaçable directement par la main d'un être humain dans le repère X, Y, Z. A cet effet, l'objet 4 pèse généralement moins de 10 kg et, de préférence, moins de 1 kg ou 250 g. Par exemple, les dimensions de l'objet 4 sont suffisamment réduites pour qu'il puisse être saisi et déplacé par une seule main d'un utilisateur.

L'objet 4 comporte un ou plusieurs dipôles magnétiques mesurables. Chaque dipôle magnétique correspond à une pièce en matériau ferromagnétique ou ferrimagnétique qui modifie les lignes du champ magnétique terrestre. De préférence, cette pièce est un aimant permanent. Un aimant permanent présente un moment magnétique non nul même en absence de champ magnétique extérieur. Par exemple, l'aimant permanent est réalisé dans un matériau magnétique dont le champ magnétique coercitif est supérieur à 100 A.m⁻¹ ou à 500 A.m⁻¹. De préférence, la puissance de cet aimant permanent est supérieure à 0,01A.m² ou 0,1A.m².

Il est également préférable que le rapport entre les puissances des aimants permanents, respectivement, le plus fort et le plus faible de l'objet soit inférieur à dix ou cinq et, avantageusement, inférieur à deux ou 1,5 ou égal à un. En effet, il a été constaté que ceci facilite la reconnaissance de l'objet 4. De préférence également, le nombre de dipôles magnétiques contenus dans l'objet 4 est supérieur ou égal à deux ou quatre pour augmenter le nombre d'objets reconnaissables. Mais un seul dipôle par objet est également possible car dans ce cas la précision sur la mesure de l'amplitude du moment magnétique est maximale ce qui augmente la fiabilité de la reconnaissance

Les dipôles magnétiques de l'objet 4 sont immobiles les uns par rapport aux autres dans l'objet 4. Par exemple, ils sont fixés sans aucun degré de liberté à un châssis de l'objet 4. Par exemple, ce châssis est en matériau non-magnétique. Un matériau non-magnétique ne présente pas de propriété magnétique mesurable par l'appareil 6. Etant donné que les dipôles magnétiques sont fixes dans l'objet 4, les distances relatives entre ces dipôles ainsi que les angles entre les moments magnétiques de ces dipôles sont constants. De même, dans ce mode de réalisation, l'amplitude et le nombre de dipôles magnétiques à l'intérieur de l'objet 4 est supposé constant.

Pour simplifier la figure 1, seuls deux dipôles magnétiques 10 et 12 ont été représentés dans l'objet 4.

L'objet 4 est par exemple un téléphone portable, un ordinateur portable, un crayon équipé de plusieurs aimants permanents ou tout autre objet comportant un ou plusieurs dipôles magnétiques. Dans le cas d'un téléphone portable, les deux dipôles magnétiques sont formés, respectivement, par le microphone et le haut-parleur du téléphone. En effet, ces pièces comportent des aimants permanents.

L'appareil 6 permet de localiser les dipôles magnétiques de l'objet 4 dans le repère XYZ. Par localisation, on entend ici la détermination de la position xₖ, yₖ, zₖ de chaque dipôle dans le repère XYZ et aussi la détermination de l'orientation du moment magnétique de chacun des dipôles magnétiques par rapport aux axes X, Y et Z du repère XYZ, où l'indice k identifie le dipôle magnétique parmi l'ensemble des dipôles magnétiques de l'objet 4. Par exemple, l'orientation du dipôle magnétique k, exprimée en coordonnées sphériques, est représentée par des angles θₖ et ϕₖ du moment magnétique de ce dipôle.

L'appareil 6 comporte un réseau de N magnétomètres tri-axes Mᵢⱼ. Sur la figure 1, les traits ondulés verticaux indiquent qu'une partie de l'appareil 6 n'a pas été représentée.

Typiquement, N est supérieur à cinq et, de préférence, supérieur à seize ou trente-deux. Ici, N est supérieur ou égal à soixante-quatre.

Dans ce mode de réalisation, les magnétomètres Mᵢⱼ sont alignés en lignes et en colonnes pour former une matrice. Ici, cette matrice comporte huit lignes et huit colonnes. Les indices i et j identifient, respectivement, la ligne et la colonne de cette matrice à l'intersection de laquelle se trouve le magnétomètre Mᵢⱼ. Sur la figure 1, seuls les magnétomètres Mᵢ₁, Mᵢ₂, Mᵢ₃, Mᵢ₄ et Mᵢ₈ d'une ligne i sont visibles. La position des magnétomètres Mᵢⱼ les uns par rapport aux autres est décrite plus en détail en référence à la figure 2.

Chaque magnétomètre Mᵢⱼ est fixé sans aucun degré de liberté aux autres magnétomètres. A cet effet, les magnétomètres Mᵢⱼ sont fixés sans aucun degré de liberté sur une face arrière 22 d'une plaque rigide 20. Cette plaque rigide présente une face avant 24 tournée vers l'objet 4. La plaque 20 est réalisée dan un matériau non magnétique rigide. Par exemple, la plaque 20 est en verre.

Chaque magnétomètre Mᵢⱼ mesure la direction et l'amplitude du champ magnétique perturbé par l'objet 4. Pour cela, chaque magnétomètre Mᵢⱼ mesure la norme de la projection orthogonale du champ magnétique au niveau de ce magnétomètre Mᵢⱼ sur trois axes de mesure de ce magnétomètre. Ici, ces trois axes de mesure sont orthogonaux entre eux. Par exemple, les axes de mesure de chacun des magnétomètres Mᵢⱼ sont, respectivement, parallèles aux axes X, Y et Z du repère. La sensibilité du magnétomètre Mᵢⱼ est par exemple de 4^{∗}10⁻⁷T.

Chaque magnétomètre Mᵢⱼ est raccordé par l'intermédiaire d'un bus 28 de transmission d'informations à une unité de traitement 30.

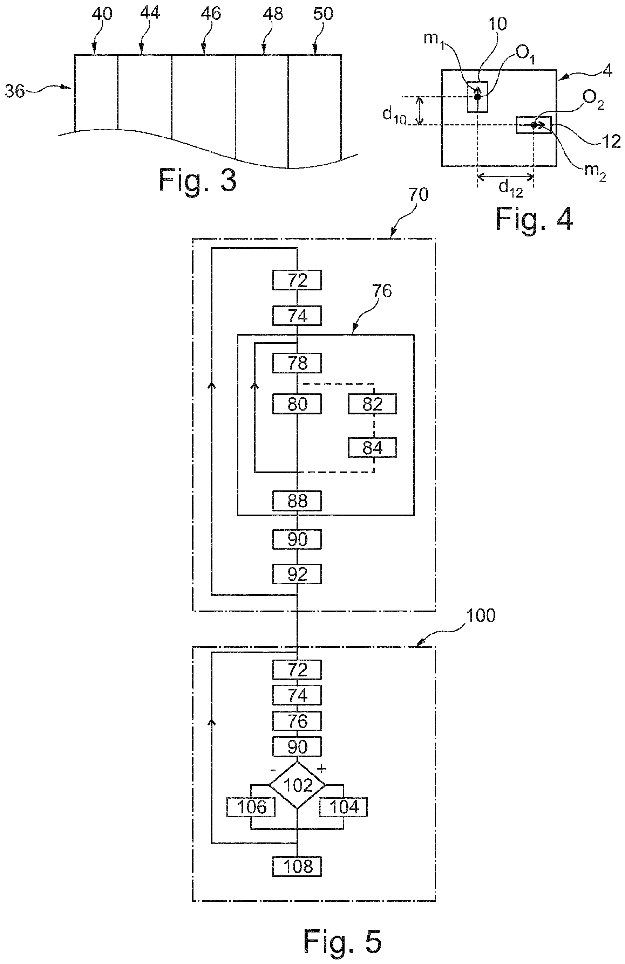

L'unité de traitement 30 est apte à mettre en œuvre le procédé de la figure 5. En particulier, elle est capable de déterminer la position et l'orientation de plusieurs dipôles de l'objet 4 dans le repère XYZ à partir des mesures des magnétomètres Mᵢⱼ. A cet effet, l'unité 30 comporte un calculateur électronique 32 programmable apte à exécuter des instructions enregistrées sur un support d'enregistrement d'informations. L'unité 30 comporte donc aussi une mémoire 34 contenant les instructions nécessaires pour l'exécution par le calculateur 32 du procédé de la figure 5. En particulier, pour chaque nombre P de dipôles magnétiques susceptibles d'être contenus dans le même objet magnétique, l'unité 30 implémente un modèle mathématique M_{P} associant chaque mesure d'un magnétomètre Mᵢⱼ aux positions, orientations et amplitudes des moments magnétiques de P dipôles magnétiques dans le repère XYZ. Chaque modèle M_{P} se présente sous la forme d'un système d'équations dans lequel un premier jeu de variables représente les positions et orientations des P dipôles magnétiques ainsi que les amplitudes des moments magnétiques de ces dipôles. Un second jeu de variables représente les mesures des magnétomètres Mᵢⱼ. Pour obtenir, les positions, orientations et amplitudes des moments magnétiques des P dipôles magnétiques, les variables du premier jeu sont les inconnues et les valeurs des variables du second jeu sont connues. Ce modèle est typiquement construit à partir des équations physiques de l'électromagnétisme. Ce modèle est paramétré par les distances connues entres les magnétomètres Mᵢⱼ. Pour construire ce modèle, chaque aimant permanent est approximé par un dipôle magnétique. Cette approximation n'introduit que très peu d'erreurs si la distance entre l'aimant permanent et le magnétomètre Mᵢⱼ est supérieure à 2L et, de préférence, supérieure à 3L, où L est la plus grande dimension de l'aimant permanent. Typiquement, L est inférieur à 20cm et, de préférence, inférieur à 10 ou 5cm.

Ici, le modèle Mₚ est non linéaire. L'unité 30 le résout en mettant en œuvre un algorithme d'estimation de sa solution. Par exemple, l'algorithme utilisé est un filtre de Kalman d'ensemble plus connu sous le terme anglais de « Unscented Kalman Filter ».

Étant donné que chaque dipôle magnétique est caractérisé par trois variables pour connaître sa position, deux variables pour connaître son orientation et une variable pour connaître l'amplitude de son moment magnétique, le nombre maximum de dipôles magnétiques simultanément localisables par le réseau de N magnétomètres est inférieur à N/2. Dès lors, la valeur du nombre P est inférieure ou égale à N/2 et, de préférence, inférieure à N/5 ou N/10 ou N/20 pour avoir des mesures redondantes. La redondance des mesures permet d'améliorer la précision de la localisation des dipôles.

Dans ce mode de réalisation, seul trois modèles mathématiques M₁, M₂ et M₃ sont implémentés dans l'unité 30.

L'unité 30 est également capable de reconnaître l'objet magnétique présenté devant l'appareil 6 par comparaison à une base de données 36 de signatures magnétiques d'objets connus. Cette base de données 36 est décrite plus en détail en référence à la figure 3.

La figure 2 représente une partie des magnétomètres Mᵢⱼ de l'appareil 6. Ces magnétomètres Mᵢⱼ sont alignés en lignes i parallèles à la direction X. Ces magnétomètres sont également alignés en colonnes j parallèles à la direction Y pour former une matrice. Les lignes i et les colonnes j sont disposées dans l'ordre des indices croissants.

La surface occupée par le réseau de magnétomètres est typiquement inférieure à 100 m² et, de préférence, inférieure à 5 m² ou 1 m² ou 50 cm².

Le centre du magnétomètre Mᵢⱼ se trouve à l'intersection de la ligne i et de la colonne j. Le centre du magnétomètre correspond au point où le champ magnétique est mesuré par ce magnétomètre. Ici, les indices i et j appartiennent à l'intervalle [1 ; 8].

Les centres de deux magnétomètres Mᵢⱼ et M_{i,j+1} immédiatement consécutifs le long d'une ligne i sont séparés par une distance connue d_{ij,j+1}. De façon similaire, le centre de deux magnétomètres Mᵢⱼ et M_{i+1,j} immédiatement consécutifs le long d'une même colonne j sont séparés par une distance connue d_{j,i,i+1}.

Dans le cas particulier décrit ici, quelle que soit la ligne i, la distance d_{i,j,j+1} est la même. Cette distance est donc notée dⱼ. De façon similaire, quelle que soit la colonne j, la distance d_{j,i,i+1} entre deux magnétomètres est la même. Cette distance est donc notée dᵢ.

Ici, les distances dᵢ et dⱼ sont toutes les deux égales à d.

Typiquement, la distance d est comprise entre 1 et 4 cm lorsque :
- la puissance de chaque aimant permanent formant chacun des P dipôles magnétiques est inférieure de 2 A.m² ou 1 A.m² ou 0,5 A.m² et, de préférence, supérieure à 0,1 A.m² ou 0,2 A.m²,
- la sensibilité des magnétomètres est de 41^{∗}10⁻⁷T, et
- le nombre de magnétomètres Mᵢⱼ est de soixante-quatre.

La figure 3 représente plus en détail la base de données 36. Cette base de données 36 contient les signatures magnétiques de plusieurs objets magnétiques connus. Ici, elle est représentée sous la forme d'une table.

Pour chaque objet connu, la base de données 36 comporte, dans une colonne 40, un identifiant « m » de cet objet connu. L'identifiant « m » identifie de façon unique cet objet connu parmi l'ensemble des objets connus enregistrés dans la base de données 36. Chaque identifiant « m » est associé par la base 36 à une signature magnétique de cet objet connu.

La signature magnétique d'un objet comporte des caractéristiques distinctives permettant d'identifier cet objet parmi l'ensemble des objets connus répertoriés dans la base de données 36.

Ici, chaque objet connu « m » est associé à une ou plusieurs caractéristiques distinctives choisies dans le groupe composé de :
- un nombre Nsₘ de dipôles magnétiques contenus dans l'objet connu « m »,
- des distances relatives Dsₘ entre les différents dipôles magnétiques de l'objet connu « m »,
- des amplitudes Asₘ des moments magnétiques des différents dipôles magnétiques de l'objet connu « m », et
- des orientations Osₘ relative des moments magnétiques des différents dipôles magnétiques de l'objet connu « m », les uns par rapport aux autres.

Dans les notations ci-dessus, l'indice « m » est l'identifiant de l'objet connu.

Les amplitudes des moments magnétiques, le nombre de dipôles magnétiques, les distances relatives et les orientations relatives , sont enregistrés, respectivement, dans les colonnes 50, 44, 46 et 48 de la base de données 36. Sur la figure 3, le trait ondulé indique que seule une partie de la base de données 36 a été représentée.

La figure 4 illustre différentes caractéristiques distinctives d'un objet magnétique connu. Ici, on suppose que l'objet magnétique connu est identique à l'objet 4 et qu'il est identifié par la valeur « 1 » de l'identifiant « m ».

Sur cette figure 4, on note :
- O₁, O₂, les centres, respectivement, des dipôles magnétiques 10 et 12,
- m₁ et m₂, les vecteurs correspondant aux moments magnétiques, respectivement, des dipôles magnétiques 10 et 12.

Ici, on considère que le centre des dipôles magnétiques est confondu avec le centre d'inertie ou le centre de gravité de l'aimant permanent correspondant à ce dipôle magnétique. Les directions des vecteurs m₁ et m₂ sont parallèles au moment magnétique, respectivement, des dipôles magnétiques 10 et 12. La longueur de ces vecteurs m₁ et m₂ est égale à l'amplitude des moments magnétiques, respectivement, des dipôles magnétiques 10 et 12.

Ici, les caractéristiques distinctives Ds₁ sont formées par le couple de distances d₁₀ et d₁₂. d₁₀ est égale à la distance la plus courte entre le centre O₁ et le plan perpendiculaire au vecteur m₁ et passant par le centre O₂. La distance d₁₂ est égale à la distance la plus courte entre le centre O₂ et le plan perpendiculaire au vecteur m₂ et passant par le centre O₁.

L'orientation relative Os₁, est l'angle entre les vecteurs m₁ et m₂.

Les amplitudes As₁ sont formées par le couple d'amplitudes A₁ et A₂ des moments magnétiques, respectivement, des dipôles 10 et 12.

Dans le cas de l'objet 4, le nombre de dipôles magnétiques est égal à deux.

Ce qui vient d'être décrit dans le cas particulier où l'objet magnétique comporte uniquement deux dipôles magnétiques, se généralise sans difficulté au cas d'objet magnétique comportant trois ou plus dipôles magnétiques.

Dans le cas où l'objet magnétique comporte un seul dipôle magnétique, les colonnes 46 et 48 sont vides, et l'objet magnétique ne peut être reconnu qu'à partir du nombre de dipôles Nsₘ et de l'amplitude Asₘ de ce dipôle magnétique.

Le fonctionnement du système 2 va maintenant être décrit en référence au procédé de la figure 5.

Ce procédé débute par une phase 70 d'enregistrement de signatures magnétiques de plusieurs objets magnétiques connus dans la base de données 36 et d'association à chacune de ces signatures d'un identifiant d'objet connu.

Pour cela, par exemple, lors d'une étape 72, on place l'objet connu devant la face 24. Lors de cette étape, il n'est pas nécessaire de positionner et d'orienter cet objet connu selon une position ou une orientation prédéterminée. Au contraire, la position et l'orientation de l'objet peuvent être quelconque.

Ensuite, lors d'une étape 74, les magnétomètres Mᵢⱼ mesurent simultanément le champ magnétique en présence de l'objet connu.

Ensuite, lors d'une étape 76, l'unité 30 détermine à partir des mesures des magnétomètres Mᵢⱼ la position, l'orientation et l'amplitude du moment magnétique de chacun des dipôles magnétiques de l'objet connu, ainsi que le nombre de dipôles magnétiques de cet objet connu.

Pour cela, lors d'une opération 78, l'unité 30 résout le système d'équations du modèle M₁ à un dipôle magnétique. Elle obtient un jeu de coordonnées x₁, y₁, z₁, θ₁ et ϕ₁ et une amplitude A₁ pour le dipôle magnétique contenu dans cet objet connu.

Ensuite, lors d'une opération 80, l'unité 30 calcule une erreur E₁ représentative de l'écart entre :
- l'estimation des valeurs mesurées par les magnétomètres, calculées à partir du système d'équations M₁ et à partir des positions, orientations et amplitudes obtenues à l'issue de l'opération 78, et
- les valeurs des mesures des magnétomètres relevées lors de l'étape 74.

Dans le cas où l'algorithme utilisé pour résoudre le modèle est un filtre de Kalman d'ensemble ou étendu, la résolution de ce système d'équations lors de l'opération 78 fournit également une estimation de cette erreur E₁.

Les étapes 78 et 80 sont réalisées pour P = 1 jusqu'à P = 3. De préférence, les étapes 78 et 80 pour chaque valeur de P sont réalisées en parallèle.

Ensuite, lors d'une opération 88, l'unité 30 sélectionne le résultat obtenu avec le modèle M_{P} qui donne l'erreur E_{P} la plus petite. Ainsi, si l'objet connu comporte un seul aimant permanent, l'unité 30 sélectionne automatiquement le modèle M₁. Si l'objet connu comporte deux, respectivement trois, aimants permanents, l'unité 30 sélectionne alors automatiquement le modèle M₂, respectivement, M₃.

A l'issue de cette étape 76, le nombre de dipôles magnétiques, la position, l'orientation et l'amplitude de chacun de ces dipôles magnétiques de l'objet magnétique est déterminé.

Lors d'une étape 90, l'unité 30 calcule les caractéristiques distinctives de l'objet connu à partir des positions, orientations et amplitudes sélectionnées lors de l'opération 88. Le calcul de ces caractéristiques distinctives se déduit des explications données en référence à la figure 4.

Enfin, lors d'une étape 92, l'unité 30 enregistre dans la base de données 36 la valeur de l'identifiant « m » associée aux différentes caractéristiques distinctives calculées lors de l'étape 90. Les différentes caractéristiques distinctives enregistrées forment alors la signature magnétique de cet objet connu.

Les étapes 72 à 92 sont ensuite réitérées pour un grand nombre d'objets connus différents les uns des autres par la position, l'orientation ou l'amplitude des dipôles magnétiques qu'ils contiennent.

Une fois que la base de données 36 a été peuplée de plusieurs signatures magnétiques d'objets connus, on procède alors à une phase 100 de reconnaissance automatique d'un objet inconnu. Par la suite, pour simplifier la description, on suppose que cet objet inconnu est l'objet 4.

La phase 100 est identique à la phase 70 sauf que l'étape 92 est remplacée par des étapes 102 à 108. Par conséquent, seules ces étapes 102 à 108 vont maintenant être décrites en détail.

Lors de l'étape 102, l'unité 30 compare les caractéristiques distinctives calculées pour l'objet 4 aux caractéristiques distinctives contenues dans chaque signature magnétique pré-enregistrée dans la base de données 36. Par exemple, on considère qu'une caractéristique distinctive mesurée correspond à une caractéristique distinctive pré-enregistrée dans la base de données 36 si ces caractéristiques distinctives sont égales à une marge d'erreur ε près. Par exemple, la marge d'erreur ε est égale à plus ou moins 1 % ou plus ou moins 5 % ou plus ou moins 10 %.

Si lors de l'étape 102, il est établi que l'objet 4 correspond à l'une des signatures magnétiques pré-enregistrées dans la base de données 36, alors lors d'une étape 104, l'identifiant de l'objet connu correspondant à cette signature est enregistré. Ici, l'identifiant de l'objet reconnu est enregistré dans une file d'attente de taille Q. A l'inverse, si lors de l'étape 102, il est établi que l'objet 4 ne correspond à aucune des signatures magnétiques enregistrées dans la base de données 36, alors lors d'une étape 106, l'unité 30 enregistre l'information selon laquelle l'objet 4 n'a pas été reconnu. Ici, une valeur nulle est enregistrée dans la file d'attente et non pas un identifiant « m ».

Les étapes 72 à 106 sont réitérées Q fois. Par exemple, Q est supérieur ou égal à 10, 20 ou 30.

Ensuite, si le même objet est reconnu dans plus de 50 %, 75 % ou 95 % des Q itérations des étapes 72 à 106, alors lors d'une étape 108, l'unité 30 indique que l'objet 4 est reconnu et, typiquement, fournit un identifiant de l'objet connu. Dans le cas contraire, lors de l'étape 108, l'unité 30 indique que l'objet 4 n'a pas été reconnu. Par exemple, l'identifiant de l'objet reconnu est communiqué à l'utilisateur par l'intermédiaire d'une interface homme-machine.

Lors de la présentation de l'objet magnétique pendant la phase 70 ou 100 devant la face 24, l'objet magnétique n'a pas besoin d'être immobile. Il peut se déplacer entre deux itérations successives des étapes de la phase 70 ou 100. L'objet magnétique peut aussi être présenté dans une position et une orientation quelconque. Cela est dû au fait que les caractéristiques distinctives ne varient pas en fonction de la position et de l'orientation de l'objet magnétique. De préférence l'objet reste proche de la matrice de capteurs.

De nombreux autres modes de réalisation sont possibles. Par exemple, les mesures des magnétomètres peuvent être enregistrées dans un premier temps. Ensuite, les étapes 76 à 108 sont réalisées ultérieurement à un moment où l'objet magnétique n'est plus présent devant la face 24 du réseau de magnétomètres. De même l'exécution du procédé de la figure 5 peut être répartie sur plusieurs calculateurs électroniques. Par exemple, les étapes 90 à 108 sont exécutées par un calculateur électronique programmable distinct du calculateur 32 qui exécute seulement l'étape 76.

La phase 70 d'enregistrement peut être réalisée différemment. Par exemple, les caractéristiques distinctives sont calculées à partir de mesures fournies par d'autres appareils que l'appareil 6. Ainsi, la distance relative des dipôles magnétiques peut être mesurée à l'aide d'une règle puis enregistrée dans la base de données 36. L'orientation et l'amplitude des moments magnétiques des dipôles magnétiques des objets connus peuvent être mesurées à l'aide d'un magnétomètre autre que ceux du réseau de magnétomètres Mᵢⱼ.

La reconnaissance de l'objet magnétique peut se faire en n'utilisant qu'une seule des caractéristiques distinctives ou en n'utilisant qu'une partie des caractéristiques distinctives précédemment décrites. Par exemple, seul l'amplitude Asₘ ou la distance relative Dsₘ est utilisée.

La caractéristique distinctive peut également être différente de celles décrite. Par exemple, cette caractéristique distinctive peut être l'amplitude relative des dipôles magnétiques entre eux. En effet, comme les autres caractéristiques distinctives, cette caractéristique distinctive ne dépend pas de la position et de l'orientation de l'objet magnétique.

Il n'est pas nécessaire que les distances relatives, les orientations relatives et les amplitudes des moments magnétiques ou le nombre de dipôles magnétiques soient tous constants au cours du temps. Si l'une des caractéristiques distinctives de l'objet magnétique varie au cours du temps, la signature de cet objet ne comporte que les caractéristiques distinctives de l'objet 4 qui ne varient pas au cours du temps et seules ces caractéristiques distinctives invariables au cours du temps sont utilisées pour la reconnaissance de cet objet. Par exemple, l'amplitude de l'un des moments magnétiques peut varier au cours du temps entre un état dans lequel l'objet 4 est alimenté ou allumé et un état dans lequel l'objet 4 est éteint ou non alimenté. Dans ce cas, pour reconnaître cet objet magnétique, seule la distance relative ou l'orientation relative des moments magnétiques des dipôles magnétiques est utilisée. Pour ce dernier cas, une autre solution consiste à enregistrer dans la base de données 36 une première signature magnétique de l'objet lorsqu'il est allumé et une seconde signature lorsqu'il est éteint. Ainsi, en plus de reconnaître l'objet, cela permet aussi d'indiquer s'il est éteint ou allumé.

Les caractéristiques distinctives peuvent être calculées de façon différente de ce qui a été décrit précédemment. Par exemple, la distance relative entre deux dipôles magnétiques peut être représentée par la valeur de la distance la plus courte entre les centres de ces deux dipôles magnétiques plutôt que par les distances d₁₀ et d₁₂.

Lors de l'opération 88, on peut sélectionner les résultats obtenus avec le premier modèle M_{P} utilisé pour lequel l'erreur E_{P} est inférieure à un seuil prédéterminé.

L'algorithme d'estimation utilisé pour résoudre le système d'équations reliant les mesures des magnétomètres aux positions, orientations et amplitudes des dipôles de l'objet magnétique peut être différent d'un filtre de Kalman étendu. Par exemple, il peut s'agir de l'algorithme LMA (« Levenberg-Marquard Algorithm »). Dans le cas d'autres algorithmes d'estimation que les filtres de Kalman, l'erreur E_{P} peut être calculée différemment. Dans ce cas, l'opération 80 est remplacée par des opérations 82 et 84 (représentées en pointillés sur la figure 5).

Lors de l'opération 82, l'unité 30 résout le modèle direct du modèle M_{P} utilisé lors de l'opération 78. Autrement dit, lors de cette opération, les variables du système d'équations dont la valeur est connue sont les variables représentant la localisation et l'amplitude des dipôles magnétiques et les variables dont les valeurs sont inconnues sont celles représentant les mesures de chacun des magnétomètre Mᵢⱼ.

Lors de l'opération 84, l'unité 30 calcule la différence entre la mesure estimée lors de l'opération 82 et la mesure relevée lors de l'étape 74. La valeur absolue de cette différence constitue l'erreur E_{P}.

De nombreux autres modes de comparaison des caractéristiques distinctives mesurées aux signatures magnétiques pré-enregistrées sont possibles. Par exemple, l'unité 30 calcule l'écart entre les caractéristiques distinctives mesurées et pré-enregistrées pour chaque signature magnétique puis on considère que l'objet à reconnaître est l'objet connu pour lequel cet écart est le plus petit.

Lors de l'étape 108, le filtrage des résultats de l'identification de l'objet connu correspondant à l'objet à reconnaître peut être réalisé différemment de ce qui a été décrit où omis. Dans le cas où le filtrage est omis, la file d'attente est omise et le nombre Q de réitérations est égal à un par exemple. Cela permet d'accélérer notablement le procédé de reconnaissance. Par exemple, ce dernier mode de réalisation est préféré lorsque la précision des magnétomètres est suffisante pour permettre une reconnaissance correcte à chaque itération de l'étape 80.

La sélection du modèle présentant l'erreur E_{P} minimale peut également être omise. Par exemple, dans un mode de réalisation particulier, un seul modèle M_{P} est systématiquement utilisé. Cela permet de simplifier l'appareil de reconnaissance dans le cas où l'on sait à l'avance que tous les objets à reconnaître présentent tous un nombre constant P de dipôles magnétiques.

Un dipôle magnétique peut être créé par autre chose qu'un aimant permanent. Par exemple, un dipôle magnétique peut être créé par l'interaction entre le champ magnétique terrestre et une pièce en matériau magnétique doux de l'objet à reconnaître. Un matériau magnétique est considéré comme doux si son champ magnétique coercitif est inférieur à 10 ou 1 A.m⁻¹.

Les aimants permanents de l'objet à reconnaître peuvent participer au fonctionnement de cet objet. C'est par exemple le cas lorsque les aimants permanents sont les aimants permanents du haut-parleur et du microphone. Toutefois, en variante, les aimants permanents peuvent être ajoutés à l'objet à reconnaître en vue de permettre sa reconnaissance par l'appareil 6. Par exemple, des aimants permanents sont ajoutés à un crayon et à un effaceur à des emplacements différents sur chacun de ces ustensiles de manière à ce que l'appareil 6 puisse distinguer le crayon de l'effaceur.

## Revendications

1. Procédé de reconnaissance automatique d'un objet magnétique comportant au moins un dipôle magnétique mesurable et présenté devant un réseau de magnétomètres comportant N magnétomètres tri-axes (Mᵢⱼ) reliés mécaniquement les uns aux autres sans aucun degré de liberté pour conserver une distance connue entre chacun de ces magnétomètres, où N est un nombre entier supérieur ou égal à cinq, ce procédé comportant :
a) lorsque l'objet magnétique est présenté devant le réseau de magnétomètres, la mesure (74) par chacun des magnétomètres de l'amplitude du champ magnétique le long de chacun de ses axes de mesure,
b) la détermination (76), à partir des mesures des magnétomètres, de la position, de l'orientation et de l'amplitude du moment magnétique de chacun de P dipôles magnétiques, où P est un nombre entier supérieur ou égal à un et inférieur ou égal à N/2, en résolvant un système prédéterminé d'équations reliant chaque mesure d'un magnétomètre tri-axe du réseau aux positions, orientations et amplitudes des moments magnétiques de P dipôles magnétiques distincts,
c) le calcul (80 ; 82, 84) d'une erreur représentative de l'écart entre :
- une estimation des valeurs des mesures des magnétomètres lorsque les positions, orientations et amplitudes des moments magnétiques des P dipôles sont égales à celles déterminées lors de l'étape b), et
- les valeurs des mesures des magnétomètres relevées lors de l'étape a),
d) la sélection d'un autre système d'équations reliant chaque mesure d'un magnétomètre tri-axe à la position, l'orientation et l'amplitude du moment magnétique de P' dipôles magnétiques, où P' est un entier naturel différent de P, puis la réitération des étapes b) et c) avec cet autre système d'équations,
e) le calcul (90) d'au moins une caractéristique distinctive de l'objet présenté à partir de la position ou de l'orientation ou de l'amplitude du moment magnétique de chaque dipôle déterminée lors de l'étape b) avec le système d'équations qui minimise l'erreur calculée lors de l'étape c), la caractéristique distinctive étant choisie, si le nombre de dipôles magnétiques dans le système d'équations qui minimise l'erreur calculée lors de l'étape c) est strictement supérieur à un, dans le groupe composé de :
- la position relative des dipôles magnétiques les uns par rapport aux autres,
- l'orientation des moments magnétiques des dipôles magnétiques les uns par rapport aux autres,
- les amplitudes des moments magnétiques des dipôles ou les amplitudes relatives des moments magnétiques des dipôles magnétiques les unes par rapport aux autres, et
- le nombre de dipôles magnétiques identifiés dans l'objet magnétique présenté,
et sinon dans le groupe composé de :
- l'amplitude du moment magnétique de ce dipôle, et
- le nombre de dipôles magnétiques identifiés dans l'objet magnétique présenté,
f) la comparaison (102) de chaque caractéristique distinctive calculée lors de l'étape e) à une caractéristique distinctive correspondante pré-enregistrée pour un objet connu,
g) la reconnaissance (108) de l'objet magnétique présenté si les caractéristiques distinctives calculées correspondent à celles de l'objet connu, sinon l'absence de reconnaissance de cet objet.

2. Procédé selon la revendication 1, dans lequel le nombre P de dipôles magnétiques est systématiquement strictement supérieur à un.

3. Procédé selon l'une quelconque des revendications précédentes, dans lequel le système d'équations est résolu en mettant en œuvre un algorithme d'estimation apte à résoudre un système d'équations non linéaire.

4. Support (34) d'enregistrement d'information, **caractérisé en ce qu'**il comporte des instructions pour la mise en œuvre des étapes c) à g) d'un procédé conforme à l'une quelconque des revendications précédentes, lorsque ces étapes sont exécutées par un calculateur électronique.

5. Appareil de reconnaissance automatique d'un objet magnétique mobile comportant au moins un dipôle magnétique mesurable, cet appareil comportant :
- un réseau de magnétomètres comportant N magnétomètres tri-axes (Mᵢⱼ) reliés mécaniquement les uns aux autres sans aucun degré de liberté pour conserver une distance connue entre chacun de ces magnétomètres, où N est un nombre entier supérieur ou égal à cinq,
- un calculateur électronique (32) programmé pour :
b) déterminer, à partir des mesures des magnétomètres, la position, l'orientation et l'amplitude du moment magnétique de chacun de P dipôles magnétiques, où P est un nombre entier supérieur ou égale à un et inférieur ou égal à N/2, en résolvant un système prédéterminé d'équations reliant chaque mesure d'un magnétomètre tri-axe du réseau aux positions, orientations et amplitudes des moments magnétiques de P dipôles magnétiques distincts,
c) calculer une erreur représentative de l'écart entre :
- une estimation des valeurs des mesures des magnétomètres lorsque les positions, orientations et amplitudes des moments magnétiques des P dipôles sont égales à celles déterminées lors de l'étape b), et
- les valeurs des mesures des magnétomètres utilisées lors de l'étape b),
d) sélectionner un autre système d'équations reliant chaque mesure d'un magnétomètre tri-axe à la position, l'orientation et l'amplitude du moment magnétique de P' dipôles magnétiques, où P' est un entier naturel différent de P, puis réitérer les étapes b) et c) avec cet autre système d'équations,
e) calculer au moins une caractéristique distinctive de l'objet présenté à partir de la position ou de l'orientation ou de l'amplitude du moment magnétique de chaque dipôle déterminée lors de l'étape b) avec le système d'équations qui minimise l'erreur calculée lors de l'étape c), la caractéristique distinctive étant choisie, si le nombre de dipôles magnétiques dans le système d'équations qui minimise l'erreur calculée lors de l'étape c) est strictement supérieur à un, dans le groupe composé de :
- la position relative des dipôles magnétiques les uns par rapport aux autres,
- l'orientation des moments magnétiques des dipôles magnétiques les uns par rapport aux autres,
- les amplitudes des moments magnétiques des dipôles ou les amplitudes relatives des moments magnétiques des dipôles magnétiques les unes par rapport aux autres, et
- le nombre de dipôles magnétiques identifiés dans l'objet magnétique présenté,
et sinon dans le groupe composé de :
- l'amplitude du moment magnétique de ce dipôle, et
- le nombre de dipôles magnétiques identifiés dans l'objet magnétique présenté,
f) comparer chaque caractéristique distinctive calculée lors de l'étape e) à une caractéristique distinctive correspondante pré-enregistrée pour un objet connu,
g) reconnaître l'objet magnétique présenté si les caractéristiques distinctives calculées correspondent à celles de l'objet connu, sinon l'absence de reconnaissance de cet objet.

6. Système d'identification comportant :
- un objet magnétique (4) à reconnaître contenant plusieurs aimants permanents (10, 12), et
- un appareil (6) de reconnaissance automatique de l'objet magnétique conforme à la revendication 5,
**caractérisé en ce que** le rapport entre la puissance de l'aimant permanent le plus fort de l'objet et la puissance de l'aimant permanent le plus faible de l'objet est inférieur à cinq.

## Patentansprüche

1. Verfahren zur automatischen Erkennung eines magnetischen Objekts, das mindestens einen messbaren magnetischen Dipol umfasst und vor einem Magnetometer-Netzwerk präsentiert wird, das N Dreiachs-Magnetometer (Mᵢⱼ) umfasst, die miteinander mechanisch ohne irgendeinen Freiheitsgrad verbunden sind, um einen bekannten Abstand zwischen jedem dieser Magnetometer zu bewahren, wobei N eine ganze Zahl größer oder gleich fünf ist, wobei dieses Verfahren umfasst:
a) wenn das magnetische Objekt vor dem Magnetometer-Netzwerk präsentiert wird, das Messen (74) der Amplitude des Magnetfeldes durch jedes der Magnetometer entlang jeder von dessen Messachsen,
b) das Bestimmen (76) der Lage, der Ausrichtung und der Amplitude des magnetischen Moments jedes der P magnetischen Dipole, wobei P eine ganze Zahl größer oder gleich eins und kleiner oder gleich N/2 ist, anhand der Messungen der Magnetometer durch Lösen eines vorbestimmten Gleichungssystems, das jede Messung eines Dreiachs-Magnetometers des Netzwerks mit den Lagen, Ausrichtungen und Amplituden der magnetischen Momente von P verschiedenen magnetischen Dipolen verknüpft,
c) das Berechnen (80; 82, 84) eines Fehlers, der repräsentativ ist für die Differenz zwischen:
- einer Schätzung der Werte der Messungen der Magnetometer, wenn die Lagen, Ausrichtungen und Amplituden der magnetischen Momente der P Dipole gleich den im Verfahrensschritt b) bestimmten sind, und
- den im Verfahrensschritt a) erfassten Werten der Messungen der Magnetometer,
d) das Auswählen eines anderen Gleichungssystems, das jede Messung eines Dreiachs-Magnetometers mit der Lage, der Ausrichtung und der Amplitude des magnetischen Moments von P' magnetischen Dipolen verknüpft, wobei P' eine ganze natürliche Zahl ungleich P ist, dann das Wiederholen der Verfahrensschritte b) und c) mit diesem anderen Gleichungssystem,
e) das Berechnen (90) mindestens eines Unterscheidungsmerkmals des präsentierten Objekts anhand der Lage oder der Ausrichtung oder der Amplitude des magnetischen Moments jedes Dipols, die im Verfahrensschritt b) mit dem Gleichungssystem bestimmt wurde, das den im Verfahrensschritt c) berechneten Fehler minimiert, wobei das Unterscheidungsmerkmal, wenn die Anzahl von magnetischen Dipolen in dem Gleichungssystem, das den im Verfahrensschritt c) berechneten Fehler minimiert, streng größer als eins ist, aus der Gruppe gewählt wird, die besteht aus:
- der relativen Lage der magnetischen Dipole zueinander,
- der Ausrichtung der magnetischen Momente der magnetischen Dipole zueinander,
- den Amplituden der magnetischen Momente der Dipole oder den relativen Amplituden der magnetischen Momente der magnetischen Dipole zueinander, und
- der Anzahl von magnetischen Dipolen, die im präsentierten magnetischen Objekt ermittelt wurden,
und ansonsten aus der Gruppe, die besteht aus:
- der Amplitude des magnetischen Moments dieses Dipols und
- der Anzahl von magnetischen Dipolen, die im präsentierten magnetischen Objekt ermittelt wurden,
f) das Vergleichen (102) jedes im Verfahrensschritt e) berechneten Unterscheidungsmerkmals mit einem entsprechenden Unterscheidungsmerkmal, das für ein bekanntes Objekt vorab gespeichert wurde,
g) das Erkennen (108) des präsentierten magnetischen Objekts, wenn die berechneten Unterscheidungsmerkmale denen des bekannten Objekts entsprechen, ansonsten Nichterkennen dieses Objekts.

2. Verfahren nach Anspruch 1, bei dem die Anzahl P von magnetischen Dipolen systematisch streng größer als eins ist.

3. Verfahren nach einem der vorhergehenden Ansprüche, bei dem das Gleichungssystem gelöst wird, indem ein Schätzalgorithmus eingesetzt wird, der geeignet ist, ein nichtlineares Gleichungssystem zu lösen.

4. Datenspeichermedium (34), **dadurch gekennzeichnet, dass** es Befehle zum Ausführen der Verfahrensschritte c) bis g) eines Verfahrens nach einem der vorhergehenden Ansprüche umfasst, wenn diese Verfahrensschritte von einem elektronischen Rechner ausgeführt werden.

5. Gerät zur automatischen Erkennung eines sich bewegenden magnetischen Objekts, das mindestens einen messbaren magnetischen Dipol umfasst, wobei dieses Gerät umfasst:
- ein Magnetometer-Netzwerk, das N Dreiachs-Magnetometer (Mᵢⱼ) umfasst, die miteinander mechanisch ohne irgendeinen Freiheitsgrad verbunden sind, um einen bekannten Abstand zwischen jedem dieser Magnetometer zu bewahren, wobei N eine ganze Zahl größer oder gleich fünf ist,
- einen elektronischen Rechner (32), der programmiert ist zum:
b) Bestimmen der Lage, der Ausrichtung und der Amplitude des magnetischen Moments jedes der P magnetischen Dipole, wobei P eine ganze Zahl größer oder gleich eins und kleiner oder gleich N/2 ist, anhand der Messungen der Magnetometer durch Lösen eines vorbestimmten Gleichungssystems, das jede Messung eines Dreiachs-Magnetometers des Netzwerks mit den Lagen, Ausrichtungen und Amplituden der magnetischen Momente von P verschiedenen magnetischen Dipolen verknüpft,
c) Berechnen eines Fehlers, der repräsentativ ist für die Differenz zwischen:
- einer Schätzung der Werte der Messungen der Magnetometer, wenn die Lagen, Ausrichtungen und Amplituden der magnetischen Momente der P Dipole gleich den im Verfahrensschritt b) bestimmten sind, und
- den im Verfahrensschritt b) verwendeten Werten der Messungen der Magnetometer,
d) Auswählen eines anderen Gleichungssystems, das jede Messung eines Dreiachs-Magnetometers mit der Lage, der Ausrichtung und der Amplitude des magnetischen Moments von P' magnetischen Dipolen verknüpft, wobei P' eine ganze natürliche Zahl ungleich P ist, dann Wiederholen der Verfahrensschritte b) und c) mit diesem anderen Gleichungssystem,
e) Berechnen mindestens eines Unterscheidungsmerkmals des präsentierten Objekts anhand der Lage oder der Ausrichtung oder der Amplitude des magnetischen Moments jedes Dipols, die im Verfahrensschritt b) mit dem Gleichungssystem bestimmt wurde, das den im Verfahrensschritt c) berechneten Fehler minimiert, wobei das Unterscheidungsmerkmal, wenn die Anzahl von magnetischen Dipolen in dem Gleichungssystem, das den im Verfahrensschritt c) berechneten Fehler minimiert, streng größer als eins ist, aus der Gruppe gewählt wird, die besteht aus:
- der relativen Lage der magnetischen Dipole zueinander,
- der Ausrichtung der magnetischen Momente der magnetischen Dipole zueinander,
- den Amplituden der magnetischen Momente der Dipole oder den relativen Amplituden der magnetischen Momente der magnetischen Dipole zueinander und
- der Anzahl von magnetischen Dipolen, die im präsentierten magnetischen Objekt ermittelt wurden, und ansonsten aus der Gruppe, die besteht aus:
- der Amplitude des magnetischen Moments dieses Dipols und
- der Anzahl von magnetischen Dipolen, die im präsentierten magnetischen Objekt ermittelt wurden,
f) Vergleichen jedes im Verfahrensschritt e) berechneten Unterscheidungsmerkmals mit einem entsprechenden Unterscheidungsmerkmal, das für ein bekanntes Objekt vorab gespeichert wurde,
g) Erkennen des präsentierten magnetischen Objekts, wenn die berechneten Unterscheidungsmerkmale denen des bekannten Objekts entsprechen, ansonsten Nichterkennen dieses Objekts.

6. Identifikationssystem, umfassend:
- ein zu erkennendes magnetisches Objekt (4), das mehrere Permanentmagnete (10, 12) umfasst, und
- ein Gerät (6) zur automatischen Erkennung des magnetischen Objekts nach Anspruch 5,
**dadurch gekennzeichnet, dass** das Verhältnis zwischen der Leistung des stärksten Permanentmagneten des Objekts und der Leistung des schwächsten Permanentmagneten des Objekts kleiner als fünf ist.

## Claims

1. Method for automatically recognizing a magnetic object comprising at least one measurable magnetic dipole and presented in front of an array of magnetometers comprising N tri-axial magnetometers (Mᵢⱼ) linked mechanically to one another with no degree of freedom to maintain a known distance between each of these magnetometers, in which N is an integer number greater than or equal to five, this method comprising:
a) when the magnetic object is presented in front of the array of magnetometers, the measurement (74) by each of the magnetometers of the amplitude of the magnetic field along each of its measurement axes,
b) the determination (76), from the measurements of the magnetometers, of the position, of the orientation and of the amplitude of the magnetic moment of each of P magnetic dipoles, in which P is an integer number greater than or equal to one and less than or equal to N/2, by solving a predetermined system of equations linking each measurement of a tri-axle magnetometer of the array to the positions, orientations and amplitudes of the magnetic moments of P distinct magnetic dipoles,
c) the calculation (80; 82, 84) of an error representative of the deviation between:
- an estimation of the values of the measurements of the magnetometers when the positions, orientations and amplitudes of the magnetic moments of the P dipoles are equal to those determined in the step b), and
- the values of the measurements of the magnetometers recorded in the step a),
d) the selection of another system of equations linking each measurement of a tri-axle magnetometer to the position, the orientation and the amplitude of the magnetic moment of P' magnetic dipoles, in which P' is a natural integer different from P, then the reiteration of the steps b) and c) with this other system of equations,
e) the calculation (90) of at least one distinctive characteristic of the presented object from the position or the orientation or the amplitude of the magnetic moment of each dipole determined in the step b) with the system of equations which minimizes the error calculated in the step c), the distinctive characteristic being chosen, if the number of magnetic dipoles in the system of equations which minimizes the error calculated in the step c) is strictly greater than one, from the group composed of:
- the relative position of the magnetic dipoles relative to one another,
- the orientation of the magnetic moments of the magnetic dipoles relative to one another,
- the amplitudes of the magnetic moments of the dipoles or the relative amplitudes of the magnetic moments of the magnetic dipoles relative to one another, and
- the number of magnetic dipoles identified in the presented magnetic object,
and, otherwise, from the group composed of:
- the amplitude of the magnetic moment of this dipole, and
- the number of magnetic dipoles identified in the presented magnetic object,
f) the comparison (102) of each distinctive characteristic calculated in the step e) to a corresponding distinctive characteristic pre-stored for a known object,
g) the recognition (108) of the presented magnetic object if the calculated distinctive characteristics correspond to those of the known object, otherwise the absence of recognition of this object.

2. Method according to Claim 1, in which the number P of magnetic dipoles is systematically strictly greater than 1.

3. Method according to either one of the preceding claims, in which the system of equations is resolved by implementing an estimation algorithm capable of resolving a nonlinear system of equations.

4. Information storage medium (34), **characterized in that** it comprises instructions for the implementation of the steps c) to g) of a method in accordance with any one of the preceding claims, when these steps are executed by an electric computer.

5. Device for automatically recognizing a moving magnetic object comprising at least one measurable magnetic dipole, this device comprising:
- an array of magnetometers comprising N tri-axial magnetometers (Mᵢⱼ) linked mechanically to one another with no degree of freedom to maintain a known distance between each of these magnetometers, in which N which is an integer number greater than or equal to five,
- an electric computer (32) programmed to:
b) determine, from the measurements of the magnetometers, the position, the orientation and the amplitude of the magnetic moment of each of the P magnetic dipoles, in which P is an integer number greater than or equal to one and less than or equal to N/2, by resolving a predetermined system of equations linking each measurement of tri-axial magnetometer of the array to the positions, orientations and amplitudes of the magnetic moments of P distinct magnetic dipoles,
c) calculating an error representative of the deviation between:
- an estimation of the values of the measurements of the magnetometers when the positions, orientations and amplitudes of the magnetic moments of the P dipoles are equal to those determined in the step b), and
- the values of the measurements of the magnetometers used in the step b),
d) selecting another system of equations linking each measurement of a tri-axle magnetometer to the position, the orientation and the amplitude of the magnetic moment of P' magnetic dipoles, in which P' is a natural integer different from P, then reiterating the steps b) and c) with this other system of equations,
e) calculating at least one distinctive characteristic of the presented object from the position or the orientation or the amplitude of the magnetic moment or each dipole determined in the step b) with the system of equations which minimizes the error calculated in the step c), the distinctive characteristic being chosen, if the number of magnetic dipoles in the system of equations which minimizes the error calculated in the step c) is strictly greater than one, from the group composed of:
- the relative position of the magnetic dipoles relative to one another,
- the orientation of the magnetic moments of the magnetic dipoles relative to one another,
- the amplitudes of the magnetic moments of the dipoles or the relative amplitudes of the magnetic moments of the magnetic dipoles relative to one another, and
- the number of magnetic dipoles identified in the presented magnetic object,
and, otherwise, from the group composed of:
- the amplitude of the magnetic moment of this dipole, and
- the number of magnetic dipoles identified in the presented magnetic object,
f) comparing each distinctive characteristic calculated in the step e) to a corresponding distinctive characteristic pre-stored for a known object,
g) recognizing the presented magnetic object if the calculated distinctive characteristics correspond to those of the known object, otherwise the absence of recognition of this object.

6. Identification system comprising:
- a magnetic object (4) to be recognized containing several permanent magnets (10, 12), and
- a device (6) for automatically recognizing the magnetic object in the accordance with Claim 5,
**characterized in that** the ratio between the power strongest permanent magnet of the object and the power of the weakest permanent magnet of the object is less than five.
